# EUROPEAN PATENT SPECIFICATION

(11) **EP 0 477 585 B1**
(45) Date of publication and mention of the grant of the patent: **25.01.1995**
(21) Application number: 91114681.9
(22) Date of filing: 30.08.1991
(51) Int. Cl.: B06B 3/00

(54) **Diamond coated ultrasonic probe tips**
Diamantbeschichtete Ultraschalltastspitze
Pointe d'une sonde ultrasonore recouverte, en phase vapeur, de diamant

(30) Priority: 24.10.1990 US 602987; 27.09.1990 US 590091
(43) Date of publication of application: 01.04.1992
(73) Proprietor: GENERAL ELECTRIC COMPANY, Schenectady New York 12305 (US); ULTRASONICS CORPORATION, Prichard, Alabama 36610 (US)
(72) Inventor: Slutz, David Earl, Columbus, Ohio 43235 (US); Gigl, Paul Donald, Westerville, Ohio 43081 (US); Kalbfleisch, Herbert Louis, Dauphin Island, Alabama (US); Johnson, Neil Robert, Columbus, Ohio 43212 (US)
(74) Representative: Pratt, Richard Wilson

(56) References cited:
- EP-A- 0 136 500
- WO-A-89/01384
- DE-A- 1 954 272
- US-A- 4 731 019

## Description

### Background of the Invention

The present invention relates to ultrasonic processors of the horn or probe type and more particularly to improving the longevity of the horn and tip.

Ultrasound, sound pitched above human hearing, has found many unusual uses in medicine, in industry, and in the home. Physicians use ultrasound, for example, to image fetuses, and to remove kidney stones without resorting to surgery. Physicians also treat cartilage trauma, such as "tennis elbow", with ultrasound. Industrially, ultrasound is crucial for welding plastics, cutting brittle alloys, emulsifying cosmetics, and for cleaning equipment. In the home, ultrasound can be used for dog whistles, jewelry cleaners, and burglar alarms.

Sonication is the controlled application of intense energy to liquid processing. The use of ultrasound in chemistry, sonochemistry, has recently received a great deal of attention because it provides the scientist with a unique way of introducing energy into molecules, quite different from conventional thermal heating and other high-energy processes, such as using laser light to pry molecules apart. In liquids, the chemical effects of ultrasound result from soundwaves interacting with the liquid through a process known as cavitation. Ultrasound can form bubbles which are not stable, however, and ultrasound can drive them into violent collapse. Ultrasonic waves, like all soundwaves, consist of alternating cycles of positive and negative pressure. The waves of positive pressure will increase local density in a gas or liquid by compressing molecules together. The negative pressure waves will decrease local density by pulling molecules further apart.

Once formed, the bubbles can redissolve into the liquid, they may float away, or, depending on the size of the bubble, they may grow and recompress in phase with the oscillating ultrasonic field. If the sound field is sufficiently intense, bubbles can grow so quickly and acquire such momentum that the compression wave that follows cannot stop them growing. Once out of phase with the ultrasonic field, however, the bubbles are no longer stable. The pressure within the bubble is not great enough to sustain the size of the bubble and, driven on by the next compression wave, the bubble implodes.

When gases are compressed, they heat up. As bubble cavities implode in a liquid irradiated with ultrasound, this compression happens so fast that little heat can transfer from the bubble to the liquid. Extreme high temperatures, equivalent to the range of temperatures that are found on the sun's surface, 5000°C, are generated nearly instantaneously in a localized "hot spot". In addition, the collapsing liquid while surrounding the bubble will compress the contents to pressures of hundreds of atmospheres. The whole event happens in less than a microsecond without heating the bulk of the liquid.

The basic metal used in sonic tips and horns of ultrasonic processors is titanium, aluminum, and vanadium alloy. This metal is used because of its bell metal qualities. The problem is to find a material with the same hell metal qualities that will not pit or corrode, or to bond a material to the metal that will not interfere with the vibration frequency desired. The radiofrequency generator changes a.c. into radiofrequency, which vibrates crystals in the converter. This changes electronic vibrations into physical vibrations. These vibrations cause the bell metal in the horn to vibrate. This reaction causes molecular disruption known as cavitation at the top. This action is longitudinally to the horn. The cavitation pits the horn or tip, which disrupts or alters the direction of sonic energy, thus causing loss of power. The solution is to avoid the pitting so that the sonic device can he used on a continuous basis. Heretofore, tips and horns were removed and polished which made it necessary to retune the radiofrequency generated to the horn or tip. Polishing can only he done a few times because it alters the bell metal frequency. This problem has made it difficult to use sonic techniques as a working industrial tool in any large production mode.

Standard horns and tips must he polished to remove pitting approximately every 4 or 5 hours. This necessitates the cessation of all processing activities. A standard tool typically cannot be polished more than 5 times using currently available metal alloys. A sapphire slice brazed to a horn can extend processing time to 5 times that of the horn without the sapphire slice. Unfortunately, the sapphire slice can only he applied to the horn and not to the tip, as the physical distortion which occurs during installation breaks the bond between the sapphire slice and the titanium of the tip. Further information in this field can be found in Suslick, et al., "Sounding Out New Chemistry"; New Scientist. 3 February 1990, pp 50-53; and Berliner, "Application of Ultrasonic Processors", American Biotechnology Laboratory, March 1984.

DE-A-1954272 discloses an ultrasonic dental instrument having a coating of a hard material such as diamond powder on a surface of the tip, the instrument having an oscillating frequency of 15-30 KHz and an amplitude of 0.05-0.12 mm.

Accordingly, there is a need in the art for a sonic horn or tip which can withstand sonic vibrations or the physical abuse, be heat resistant, withstand corrosion from the material which would be used in sonic exercise, and would be sufficiently inert to not significantly cause a chemical reaction in the material to be processed.

### Broad Statement of the Invention

The present invention is directed to achieving the long felt needs in the sonic processor industry described above. Broadly, the present invention is directed to a sonication device comprising an ultrasonic horn of the type having an exteriorly projecting probe having a tip, characterized in that said tip comprises a base metal alloy comprising titanium, aluminum and vanadium having at least one exterior surface comprising a thermally-stable diamond compact brazed to said tip wherein said compact comprises between 70% and 95% by volume of diamond particles and a network of interconnected empty pores and ranges in thickness from between 1 and 200 micrometers. The corresponding method for making such ultrasonic horn comprises brazing a thermally stable diamond compact to at least one exterior surface of the tip.

Advantages of the present invention include a coating on the horn which can withstand sonic vibration and is heat resistant. Another advantage is an improved horn or probe that can withstand corrosion during sonic exercise. A further advantage is an improved ultrasonic horn or probe that does not significantly cause a chemical reaction in most materials to be processed. Yet another advantage is an improved ultrasonic horn or probe that can be operated continuously for extended periods of time without having to polish or dress the horn or probe. These and other advantages will be readily apparent to those skilled in the art based upon the disclosure contained herein.

### Detailed Description of the Invention

The major components of a typical ultrasonic processor include a generator or power supply that converts conventional 50 or 60 Hz alternating currenting at 120 or 220 volts to 20 KHz electrical energy at approximately 1,000 v. This high-frequency electrical energy is fed to a converter where it is transformed to mechanical vibration. The heart of typical ultrasonic processor converters comprises transducer crystals, e.g. two or more lead zirconate titanate electrostrictive crystals which, when subjected to an alternating biasing voltage, expand and contract. The transducer crystals vibrate in the longitudinal direction and this motion is transmitted to the disruptor horn. The horn transmits and amplifies the energy, focusing it into a tip which is immersed in the biological or process solution. Motion of the tip generates the soundwaves which propagate through the liquid, generating microbubbles and causing cavitation.

Referring to the thermally-stable polycrystalline diamond compacts, reference is made to U.S. Pats. nos. 4,224,380 and 4,288,248 which provide a full disclosure thereof. Briefly, these thermally-stable polycrystalline compacts comprise diamond particles which comprise between about 70% and 95% by volume of the compact. A metallic phase of sintering aid material is present substantially uniformly throughout the compact and is in a minor amount, typically ranging from about 0.05 to about 3% by volume of the compact. A network of interconnected empty pores are dispersed through the compact and are defined by the diamond particles and the metallic phase. Such pores generally comprise between about 5% and 30% by volume of the compact. Thus, these compacts often are termed "porous compacts".

Regardless of the precise form of polycrystalline diamond chosen, it is typified by being "thermally-stable" as defined above. By being thermally-stable compacts, the compacts can be subjected to substantially higher brazing conditions which enables sufficient wetting of the diamond particles for their attachment to the horn or probe processor drill heads. It will be appreciated that diamond is the most difficult of materials to wet. Since catalytic metal is substantially absent from thermally-stable compacts, the compacts can be subjected to higher brazing temperatures without fear of degradation of the compacts due to the difference in thermal expansion between metal catalyst and the diamond itself. Since the thermally-stable compacts are not supported, i.e. with tungsten carbide or the like, adequate wetting of the particles by the brazing alloy is required. In this regard, it will be appreciated that the thermally-stable compacts can be coated with a metal to enhance their oxidation resistance during the brazing operation and/or to improve the bonding of the compacts to the drill head, such as disclosed, for example, in U.S. Pat. No. 4,738,689. Suitable coatings include, for example, nickel, copper, titanium, tungsten, niobium, zirconium, vanadium, molybdenum, and alloys, compounds, and mixtures thereof. Coating thicknesses advantageously can be at least about 8 microns and can range on up to 150 microns or more.

The compacts brazed to the horn or probe appear to be effectively supported so that the brazing alloy composition becomes more tolerant with respect to choice. A wide variety of brazing alloys should function efficaciously, though high liquidus brazing alloys are preferred by the art.

Referring to the brazing alloys having a liquidus greater than 700°C and which are useful in accordance with the precepts of the present invention, a wide variety of such braze alloys are known in the art. For example, Anaconda 773 filler metal (copper 50%, zinc 40%, nickel 10%, melting point range 950°-960°C) can be used, though it has been reported to undesirably react with carbide pieces being joined, so that its use with carbide drills may not be recommended. Another brazing filler metal which has been proposed is TiCuSil (Ti-4.5%, Cu-26.7%, Ag-balance, melting point range 840°-850°C). However, TiCuSil does not braze well unless brazing is conducted under vacuum or inert atmosphere, but is the presently-preferred brazing alloy tested to date. Other alloys include a palladium (28-32%), chromium (6%-13%), boron (1%-3.5%), and nickel (balance) brazing alloy described and claimed in U.S. Pat. No. 4,414,178. This alloy is described as being capable of brazing in the 982°-1093°C temperature range. Additionally, U.S. Pat. No. 4,527,998 discloses additional gold-based alloys as follows: gold (18%-39.5%), nickel (3.5%-14.5%), palladium (2.5%-10.5%), manganese (7.5%-9.0%), and copper (balance). Most brazing alloy compositions reported within these ranges have liquidus between 90)° and 1,000°C. Finally, U.S. Pat. No. 4,899,922 proposes the use of brazing alloys having a liquidus above 700°C and containing an effective amount of chromium for bonding of thermally-stable compacts. Titanium-hearing brazing alloys are preferred for brazing thermally-stable polycrystalline diamond compacts, e.g. EZ Flow 3 (630°C-695°C liquidus) and EZ Flow (605°C-640°C liquidus), following their coating with W and heat treating. For thermally-stable CBN, TiCuSil or similar vacuum braze is preferred.

Testing of 0.2 mm (0.008 in) CVD coatings brazed on ultrasonic horns and probes with TiCuSil braze alloy have revealed no perceptible tipwear, characteristic metal discoloration, or pitting of the tip surface after over 1,000 hours of continuous use in a liquid composed of 40% water and 60% heavy oil (80-120 wt).

## Claims

1. A sonication device comprising an ultrasonic horn of the type having an exteriorly projecting probe having a tip, characterized in that said tip comprises a base metal alloy comprising titanium, aluminum and vanadium having at least one exterior surface comprising a thermally-stable diamond compact layer brazed to said tip wherein said compact comprises between 70% and 95% by volume of diamond particles and a network of interconnected empty pores and ranges in thickness from between 1 and 200 micrometers.

2. The device of Claim 1 wherein said layer ranges in thickness from between 1 and 400 micrometers.

3. The device of Claim 1 wherein said layer is brazed onto the exterior surfaces of the horn or probe.

4. The device of Claim 3 wherein said brazing alloy has a liquidus greater than 700°C.

5. The device of Claim 4 wherein said brazing alloy is selected from the group consisting of : copper-50%, zinc-40%, nickel-10%, melting point range 950°-960°C; titanium-4.5%, copper-26.7%, silver-balance, melting point range 840°-850°C; gold-18%-39.5%, nickel-3.5%-14.5%, palladium-2.5%-10.5%, manganese-7.5%-9%, and copper-balance, having a liquidus between 900° and 1,000°C; and a brazing alloy having a liquidus above 700°C and containing an effective amount of chromium for bonding of said layer.

6. A method for avoiding pitting of the horn and tip of a sonication device which comprises brazing a coating of a thermally stable diamond compact layer on at least one exterior surface of the tip, wherein said compact comprises between 70 and 95% by volume diamond particles and a network of interconnected empty pores and ranges in thickness from between 1 and 200 micrometers and said tip comprises a base metal alloy comprising titanium, aluminium and vanadium.

7. The method of Claim 6 wherein said layer is brazed onto the exterior surfaces of the horn or probe.

8. The method of Claim 6 or Claim 7 wherein the brazing alloy has a liquidus greater than 700°C.

9. The method of Claim 8 wherein said brazing alloy is selected from the group consisting of : copper-50%, zinc-40%, nickel-10%, melting point range 950°-960°C; titanium-4.5%, copper-26.7%, silver-balance, melting point range 840°-850°C; gold-18%-39.5%, nickel-3.5%-14.5%, palladium-2.5%-10.5%, manganese-7.5%-9%, and copper-balance, having a liquidus between 900° and 1,000°C; and a brazing alloy having a liquidus above 700°C and containing an effective amount of chromium for bonding of said layer.

## Patentansprüche

1. Beschallungsgerät, umfassend ein Ultraschallhorn der Art mit einer nach außen vorstehenden Sonde mit einer Spitze, dadurch gekennzeichnet, daß die Spitze eine Grundmetallegierung umfaßt, die Titan, Aluminium und Vanadium umfaßt und mindestens eine äußere Oberflache aufweist, die eine Schicht aus thermisch stabilem Diamantpreßling umfaßt, die an die Spitze hartgelötet ist, wobei die Preßlingsschicht zwischen 70 und 95 Vol.-% Diamantteilchen und ein Netzwerk miteinander verbundener leerer Poren umfaßt und eine Dicke im Bereich von 1 bis 200 »m hat.

2. Gerät nach Anspruch 1, worin die Schicht eine Dicke im Bereich von 1 bis 400 »m bat.

3. Gerät nach Anspruch 1, Worin die Schicht auf die äußeren Oberflächen des Hornes oder der Sonde hartgelötet ist.

4. Gerät nach Anspruch 3, worin die Hartlotlegierung eine Liquidustemperatur von mehr als 700°C hat.

5. Gerät nach Anspruch 4, worin die Hartlotlegierung ausgewählt ist aus der Gruppe bestehend aus: 50% Kupfer, 40% Zink, 10% Nickel, Schmelzpunktsbereich 950 bis 960°C; 4,5% Titan, 26,7% Kupfer, Rest Silber, Schmelzpunktsbereich 840 bis 850°C; 18 bis 39,5% Gold, 3,5 bis 14,5% Nickel, 2,5 bis 10,5% Palladium, 7,5 bis 9% Mangan, Rest Kupfer mit einer Liquidustemperatur zwischen 900 und 1.000°C und einer Hartlotlegierung mit einer Liquidustemperatur oberhalb 700°C, die eine wirksame Menge Chrom zum Verbinden der genannten Schicht enthält.

6. Verfahren zum Vermeiden der Grübchenbildung am Horn und der Spitze eines Beschallungsgerätes, umfassend das Hartlöten eines Überzuges aus einer thermisch stabilen Diamantpreßlingsschicht auf mindestens eine äußere Oberfläche der Spitze, worin die Preßlingsschicht zwischen 70 und 95 Vol.-% Diamantteilchen und ein Netzwerk miteinander verbundener leerer Poren umfaßt, und ihre Dicke im Bereich zwischen 1 und 200 »m liegt, und die Spitze eine Grundmetallegierung umfaßt, die Titan, Aluminium und Vanadium umfaßt.

7. Verfahren nach Anspruch 6, worin die Schicht auf die äußeren Oberflächen des Hornes oder der Sonde hartgelötet ist.

8. Verfahren nach Anspruch 6 oder 7, worin die Hartlotlegierung eine Liquidustemperatur von mehr als 700°C hat.

9. Verfahren nach Anspruch 8, worin die Hartlotlegierung ausgewählt ist ausgewählt aus der Gruppe bestehend aus: 50% Kupfer, 40% Zink, 10% Nickel, Schmelzpunktsbereich 950 bis 960°C; 4,5% Titan, 26,7% Kupfer, Rest Silber, Schmelzpunktsbereich 840 bis 850°C; 18 bis 39,5% Gold, 3,5 bis 14,5% Nickel, 2,5 bis 10,5% Palladium, 7,5 bis 9% Mangan, Rest Kupfer mit einer Liguidustemperatur zwischen 900 und 1.000°C und einer Hartlotlegierung mit einer Liquidustemperatur oberhalb 700°C, die eine wirksame Menge Chrom zum Verbinden der genannten Schicht enthält.

## Revendications

1. Dispositif pour la production d'ultrasons comprenant un cornet ultrasonique comportant une sonde s'avançant vers l'extérieur et pourvue d'une pointe, caractérisé en ce que ladite ponte comprend un alliage métallique de base comprenant du titane, de l'aluminium et du vanadium, ayant au moins une surface extérieure comprenant une couche compacte à base de diamant, thermiquement stable, brasée à ladite pointe, ladite couche compacte comprenant entre 70 et 95 % en volume de particules de diamant et un réseau de pores vides interconnectés et dont l'épaisseur est comprise entre 1 et 200 »m.

2. Dispositif selon la revendication 1 dans lequel l'épaisseur de ladite couche est comprise entre 1 et 400 »m.

3. Dispositif selon la revendication 1 dans lequel ladite couche est brasée aux surfaces extérieures du cornet ou de la sonde.

4. Dispositif selon la revendication 3 pour lequel ledit alliage de brasage présente un liquidus supérieur à 700°C.

5. Dispositif selon la revendication 4 dans lequel ledit alliage de brasage est choisi dans le groupe formé par : 50 % de cuivre, 40 % de zinc, 10 % de nickel, point de fusion compris entre 950 et 960°C ; 4.5 % de titane, 26,7 % de cuivre, le complément étant de l'argent, le point de fusion étant compris entre 840 et 850°C ; 18 à 39,5 % d'or, 3,5 à 14,5 % de nickel, 2,5 à 10,5 % de palladium, 7,5 à 9 % de manganèse, le complément étant du cuivre, ayant un liquidus entre 900°C et 1000°C ; et un alliage de brasage ayant un liquidus supérieur à 700°C et contenant une quantité efficace de chrome pour la liaison à ladite couche.

6. Procédé permettant d'éviter la formation de piqûres sur le cornet et sur la pointe d'un dispositif pour la production d'ultrasons, comprenant le brasage d'un revêtement constitué par une couche compacte à base de diamant, thermiquement stable, sur au moins une surface extérieure de la pointe, ladite couche compacte comprenant entre 70 et 95 % en volume de particules de diamant et un réseau de pores vides interconnectés et dont l'épaisseur est comprise entre 1 et 200 »m, ladite pointe comprenant un alliage métallique de base comportant du titane, de l'aluminium et du vanadium.

7. Procédé selon la revendication 6 selon lequel ladite couche est brasée sur les surfaces extérieures du cornet ou de la sonde.

8. Procédé selon la revendication 6 ou 7 lorsque l'alliage de brasage a un liquidus supérieur à 700°C.

9. Procédé selon la revendication 8 lorsque ledit alliage est choisi dans le groupe formé par : 50 % de cuivre, 40 % de zinc, 10 % de nickel, point de fusion compris entre 950 et 960°C et 4,5 % de titane, 26,7 % de cuivre, le complément étant de l'argent, le point de fusion étant compris entre 840-et 850°C ; de 18 % à 39,5 % d'or, de 3,5 % à 14,5 % de nickel de 2,5 % à 10,5 % de palladium, de 7,5 % à 9 % de manganèse, le complément étant du cuivre, ayant un liquidus entre 900°C et 1000°C ; et un alliage de brasage ayant un liquidus supérieur à 700°C et contenant une quantité efficace de chrome pour la liaison à ladite couche.
